# EUROPEAN PATENT SPECIFICATION

(11) **EP 1 524 769 B1**
(45) Date of publication and mention of the grant of the patent: **30.07.2008**
(21) Application number: 04024094.7
(22) Date of filing: 08.10.2004
(51) Int. Cl.: H03K 19/086

(54) **Current switch circuit, amplifier, and mobile terminal**
Stromschalter, Verstärker und mobiles Endgerät
Commutateur de courant, amplificateur et terminal mobile

(30) Priority: 09.10.2003 JP 2003350836
(43) Date of publication of application: 20.04.2005
(73) Proprietor: Sharp Kabushiki Kaisha, Osaka-shi, Osaka 545-8522 (JP)
(72) Inventor: Kawamura, Hiroshi, Kashihara-shi Nara 634-0805 (JP)
(74) Representative: Müller - Hoffmann & Partner

(56) References cited:
- JP-A- 2001 267 859
- US-A- 5 250 860
- US-A- 6 163 215

## Description

### FIELD OF THE INVENTION

The present invention relates to (i) a current switch circuit utilizing such a feature that a plurality of circuit blocks are sequentially switched by an analog signal, the circuit being used for a variable-gain amplifier, a variable attenuator, and a power supply, (ii) an amplifier adopting the current switch circuit, and (iii) a mobile terminal including the current switch circuit or the amplifier.

### BACKGROUND OF THE INVENTION

There are many case where a plurality of circuit blocks need to be switched to each other by an analog signal. For instance, a variable-gain amplifier is configured by sequentially switching amplifiers having different gains one another, by an analog signal, or an electronic variable attenuator is configured by sequentially switching attenuators having different attenuations, by an analog signal. In this manner, sequential switching by an analog signal is effectively utilized in many fields, e.g. a field of mobile terminals such as mobile phones, note PCs, and PDAs (Personal Digital Assistants).

As one of such methods of sequential switching, Non-Patent Literature 1 proposes a circuit including a combination of bipolar transistors and a current source, in which amplifiers are switched. Fig. 11 illustrates a circuit diagram of Non-Patent Literature 1.

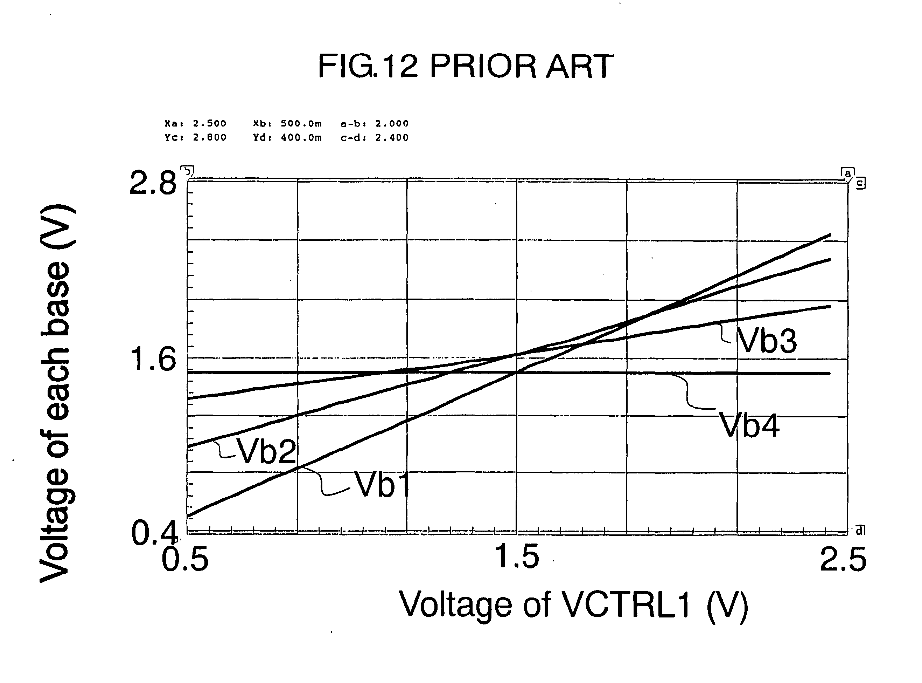

In this circuit, two control voltages of respective control voltage generating circuits VCTRL1 and VCTRL2 are varied so that values of respective currents flowing into terminals I1, I2, I3, and I4 are varied. For instance, when the voltage of the VCTRL2 is fixed to 1.5V while the voltage of the VCTRL1 is varied from 0.5V to 2.5V, base voltages of the respective transistors are varied as shown in Fig. 12.

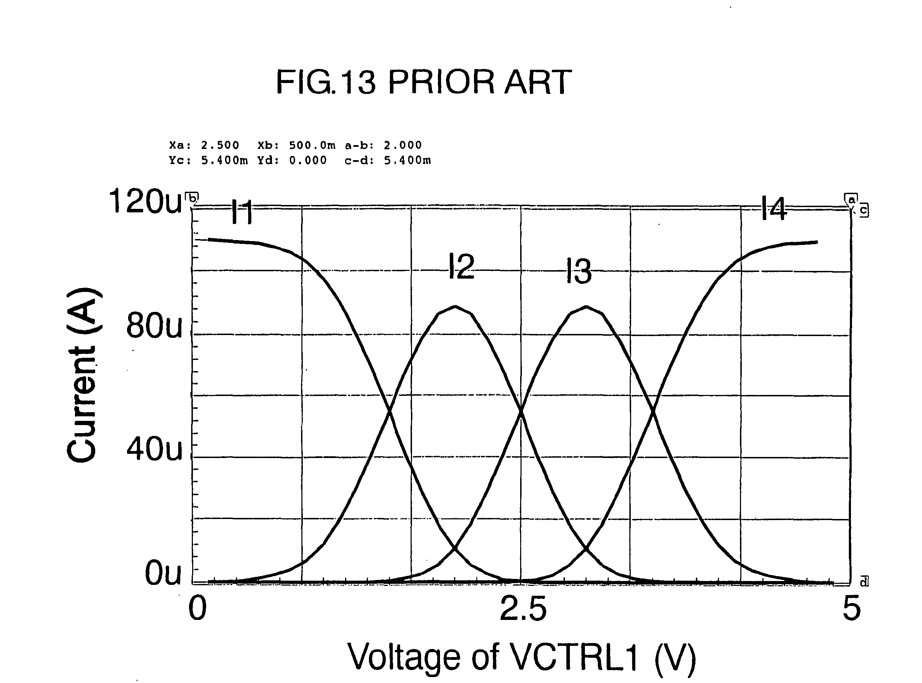

Owing to this change of the base voltages, the values of the currents flowing into the respective terminals I1, I2, I3, and I4 seamlessly change as shown in Fig. 13. The sum total of the current values of all transistors is determined by a current value of a current source connected to the emitters of the transistors, thereby being always constant.

### (Non-Patent Literature 1)

"A Low-Noise Wideband Variable-Gain Amplifier Using an Interpolated Ladder Attenuator", ISSCC Digest of Technical Papers, pp.280-281, Feb. 1991

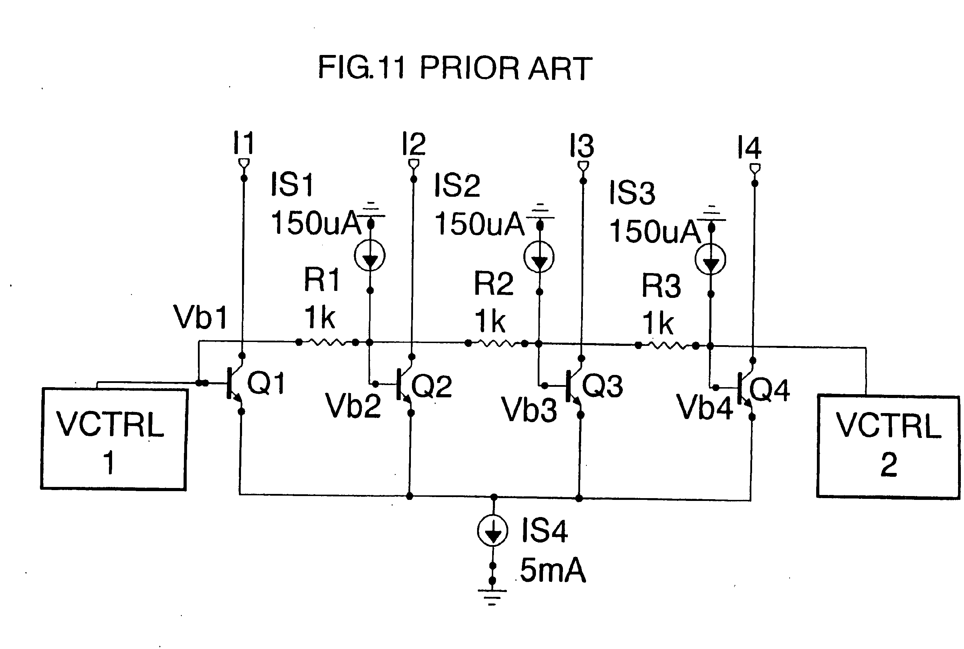

In the circuit illustrated in Fig. 11, a current about 500µA at the maximum flows from the current switch circuit into the control voltage generating circuit VCTRL1 when the control voltage is less than 1.83V, while a current about 250µA at the maximum flows into the current switch circuit from the control voltage generating circuit, when the control voltage is not less than 1.83V.

On the other hand, a current about 100µA at the maximum flows from the control voltage generating circuit VCTRL2 to the current switch circuit, when the control voltage of the control voltage generating circuit VCTRL1 is less than 0.75V, while a current about 650µA at the maximum flows from the current switch circuit into the control voltage circuit VCTRL2, when the control voltage of the control voltage generating circuit VCTRL1 is not less than 0.75V. In this wise, the control voltage generating circuit need to perform a bipolar operation which allows a current to both flow out and flow in by the control of the control voltage.

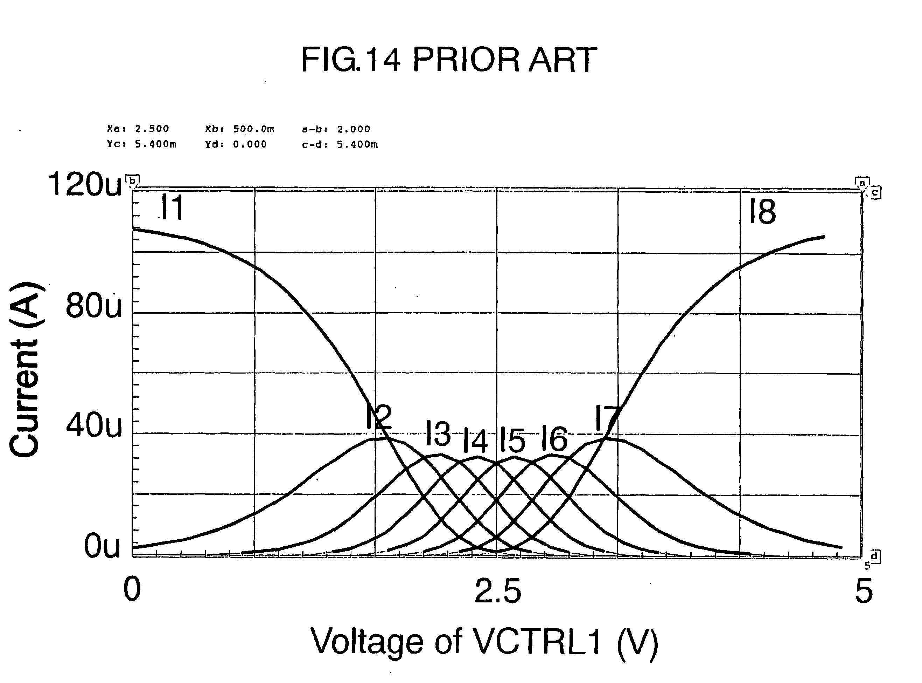

The transistors of this simulation cannot fully switch the current if the difference of the base voltages is less than about 200mV. However, as illustrated in Fig. 12, it is difficult to obtain the difference of the base voltages. For this reason, the number of switched blocks cannot be easily increased. If, for instance, the number of the switched blocks is increased to 8, it is difficult to obtain uniform switching characteristics, because current switch control voltages have maldistribution gathering around the center value of the control voltages as shown in Fig. 14.

Also, a further investigation confirms that, in addition to the necessity of the bipolar operation of the control voltage generating section, the conventional circuit has the following problem.

In the conventional circuit, there are a lot of parameters for determining the switching characteristics with regard to the control voltage, such as current values of the current source connected to the emitter, current values of the current source connected to the bases and values of resistors provided between the bases. On this account, it is difficult to arrange the switching characteristics with regard to the control voltages.

To make the switching characteristic curves be steep, it is necessary to increase the difference between the base voltages. To increase the difference, considerably high control voltages are required. A power supply voltage about 3V, which is typically used in battery-driven mobile devices, is insufficient for the above, so that the application of the conventional circuit is limited.

### SUMMARY OF THE INVENTION

The objective of the present invention is to provide: (i) a current switch circuit in which the switching of current paths can be easily controlled even with a low power supply voltage (about 3V), thereby being applicable for a wide range of use; (ii) an amplifier adopting this current switch circuit; and (iii) a mobile terminal using the current switch circuit.

To achieve this objective, a current switch circuit of the present invention is characterized by comprising: first through n-th (n is an integer not less than 2) differential pairs each including first and second control terminals, first and second switched current terminals, and one common terminal; a constant current section; a reference voltage section which supplies first through n-th reference voltages to the respective first control terminals of the first through n-th differential pairs, said first through n-th reference voltages being different from each other; and a control section which changes control voltages applied to the respective second control terminals of the first through n-th differential pairs, the common terminal of the first differential pair being connected to the constant current section, the second switched current terminal of the first differential pair being connected to the common terminal of the second differential pair, and the common terminals of the third through n-th differential pairs being connected respectively to the second switched current terminals of the second through (n-1)th differential pairs, and by the control section, a current being shifted from the first switched current terminal of the first differential pair to the second switched current terminal of the n-th differential pair, via the first switched current terminals of the second through (n-1)th differential pairs.

According to this arrangement, when the differential pairs are made up of either NPN-type bipolar transistors or N-type field effect transistors, a current is drawn to the switched current terminal on the side of the control terminal whose voltage in comparison with the voltage of the common terminal is higher than the other. On the other hand, when the differential pairs are made up of PNP-type bipolar transistors or P-type field effect transistors, a current is discharged (drained) from the switched current terminal on the side of the control terminal whose voltage in comparison with the common terminal is lower than the other.

In the arrangement above, the control voltage at the time of switching the current paths is basically equal to the reference voltage. On this account, constructing the reference voltage section by simple resistance division including a plurality of resistors in series, the current switching voltage can be easily set only by designing values of the resistors. In the arrangement above, furthermore, the differential pairs are adopted and hence no current flows into the control section. Thus, the control section is no longer required to control the bipolar operation, thereby being simplified.

Furthermore, in the arrangement above, the control voltage can be lowered by lowering the upper limits of the reference voltages. On this account, the switching of the current paths is easily controlled even if the power supply voltage is low (about 3V), and hence the arrangement can be used for a wide variety of uses.

For a fuller understanding of the nature and advantages of the invention, reference should be made to the ensuing detailed description taken in conjunction with the accompanying drawings.

### BRIEF DESCRIPTION OF THE DRAWINGS

Fig. 1 is a circuit block diagram of First Embodiment, concerning a current switch circuit of the present invention.
Fig. 2 is a circuit diagram of First Embodiment, in which bipolar transistors are adopted.
Fig. 3 is a graph showing current switching characteristics of the current switch circuit of Fig. 2.
Fig. 4 is a circuit diagram of Second Embodiment of the present invention, in which N-type MOSFETs are adopted.
Fig. 5 is a graph illustrating current switching characteristics of the current switch circuit of Fig. 4.
Fig. 6 is a graph showing current switching characteristics in a case where a value of a reference voltage setting resistor of the current switch circuit in Fig. 4 is changed.
Fig. 7 is a circuit diagram of a modified example of Second Embodiment of the present invention, which adopts P-type MOSFETs.
Fig. 8 is a circuit diagram of Third Embodiment of the present invention, which is a case where current mirroring using P-type MOSFETs is performed in a current switch circuit adopting N-type MOSFETs.
Fig. 9 is a graph illustrating the current switch characteristics of the circuit shown in Fig. 8.
Fig. 10 is a circuit block diagram showing Fourth Embodiment of the present invention, which is an example of a variable-gain amplifier composed by connecting a current switch circuit of the present invention with amplifiers whose gains are different from each other.
Fig. 11 is a circuit diagram of an example of a conventional current switch circuit.
Fig. 12 is a graph showing the control voltage characteristics of base voltages of the circuit shown in Fig. 11.
Fig. 13 is a graph showing the current switching characteristics of the circuit shown in Fig. 11.
Fig. 14 is a graph showing current switch characteristics in a case where the number of switch current paths in the circuit shown in Fig. 11 is 8.

### DESCRIPTION OF THE EMBODIMENTS

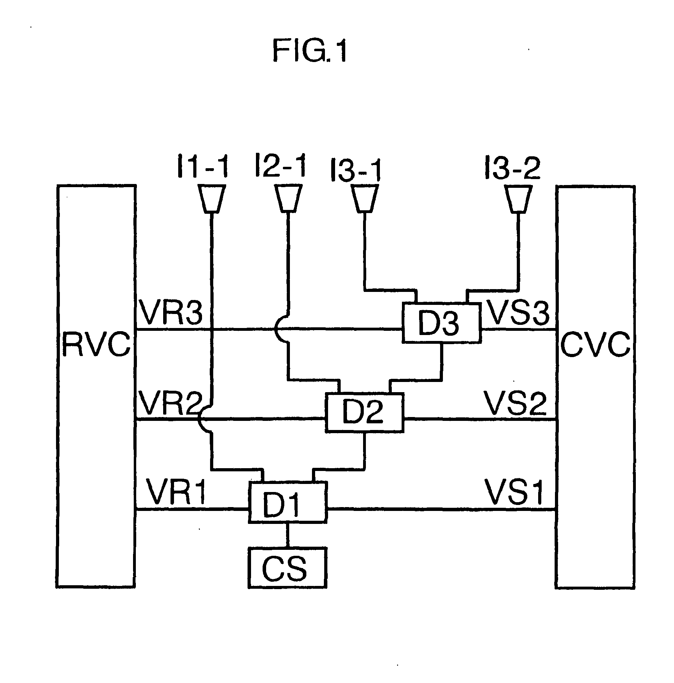

The following will discuss Embodiments of a current switch circuit of the present invention, in reference to Figs. 1-10.

### [First Embodiment]

Fig. 1 is a block diagram showing the current switch circuit of the present invention. In this current switch circuit, three differential pairs D1, D2, and D3 are cascaded (connected in series) in such a manner as to be piled up to each other. In each of these differential pairs, two terminals on the upper side of a block of each differential pair are switched current terminals, a terminal on the lower side of the block is a common terminal connected to a current source, and terminals on the right and left sides of the block are control terminals. When the differential pair is made up of either NPN-type bipolar transistors or N-type field-effect transistors, a current is drawn into the switched current terminal on the side of the control terminal whose voltage in comparison with the common terminal is higher than the voltage of the other control terminal. When the differential pair is made up of either PNP-type bipolar transistors or P-type field effect transistors, a current is discharged from the switched current terminal on the side of the control terminal whose voltage in comparison with the common terminal is lower than the voltage of the other control terminal.

The common terminal of the first differential pair is connected to a constant current circuit CS (constant current section) as the current source, and the common terminal of the second differential pair is connected to the second switched current terminal of the first differential pair. One input of each differential pair is connected to a reference voltage generating circuit (reference voltage section) RVC.

This reference voltage generating circuit RVC generates reference voltages VR1, VR2, and VR3 having different voltage levels in ascending order. The other input of each of the differential pairs D1, D2, and D3 is connected to a control voltage generating circuit (control section) CVC. In general, voltages VS1, VS2, and VS3 supplied from the control voltage generating circuit CVC are VS = VS1 = VS2 = VS3.

In the current switch circuit of the present invention, the control voltage VS at the time of switching the current path is basically identical with the reference voltage. When the reference voltage generating circuit RVC is structured as a simple resistance division including a plurality of resistors in series, the reference voltages for the current switching are easily generated only by designing values of the resistors.

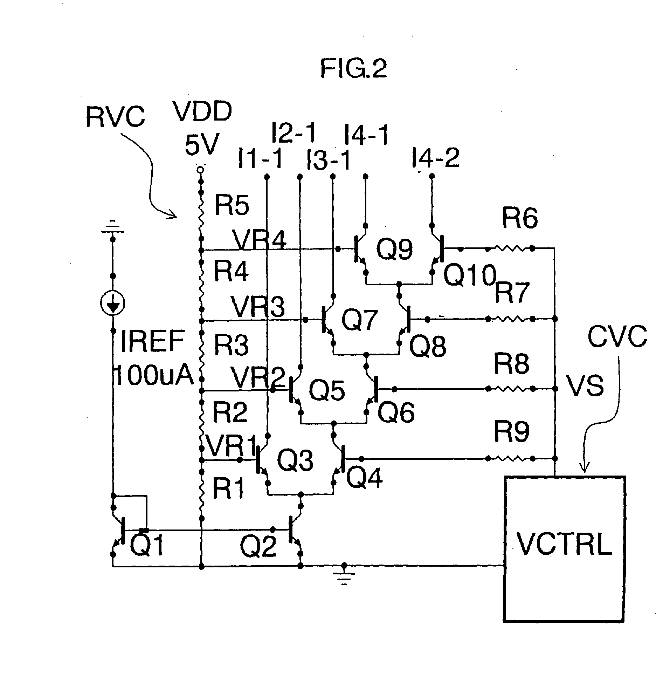

Next, a circuit diagram of the first example of First Embodiment of the present invention is illustrated in Fig. 2. In this circuit, elements of the differential pairs are NPN-type bipolar transistors. The current gain of each bipolar transistor is about 100, and the total amount of currents to be switched is 100µA. The reference voltage generating circuit RVC is structured as a simple resistance division using resistors R1 to R5, and the resistances thereof and base current limiting resistances are all 100kΩ. The power supply voltage (VDD) is 5V.

A switch current of 100µA is converted to a drawn current drawn into the Q2, by a current mirror circuit made up of the Q1 and Q2, and this current is used as the current source. The collector of the Q2 is connected to the emitters of the Q3 and Q4, and the Q3 and Q4 form a differential pair (differential circuit). The collector (first switched current terminal) of the Q3 functions as a first current drawing terminal I1-1.

The collector (second switched current terminal) of the Q4 is connected to the emitters of the Q5 and Q6 constituting a differential pair. The collector (first switched current terminal) of the Q5 functions as a second current drawing terminal I2-1. The collector (second switched current terminal) of the Q6 is connected to the emitters of the next differential pair.

Cascading and piling up the differential pairs as above, the number of switched blocks can optionally be determined without restraint. In the present embodiment, four stages of differential pairs are piled up, and five current drawing terminals I1-1, I2-1, I3-1, I4-1, and I4-2 are formed. The 100µA current source can be constructed simply by providing an appropriate resistor between the VCC and the Q1.

To reduce the variation between elements and the dependency on the power supply voltage, a circuit adopting a power supply circuit such as a bandgap power supply circuit, whose properties do not change by element properties and temperature, is preferably used as the current source. Alternatively, in some cases it is possible to use a power supply circuit which can cancel the temperature characteristics of the current switch circuit.

Now, the operation of the above will be discussed. When the control voltage VS is sufficiently lower than the first reference voltage VR1, the voltage between the base and emitter of the Q4 is low, so that the Q4 turns off and all current flows into the Q3 through the terminal I1-1. As the control voltage VS increases and approaches the first reference voltage VR1 and the voltage between the base and emitter of the Q4 increases, a current starts to flow into the Q4.

When the control voltage VS is equal to the first reference voltage VR1, the current flowing in the Q3 is equal to the current flowing in the Q4. At this point, the control voltage VS is sufficiently lower than the second reference voltage VR2, so that the voltage between the base and emitter of the Q6 is low and hence the Q6 is in the off state. On this account, all of the current flowing in the Q4 flows into the Q5 via the I2-1 terminal.

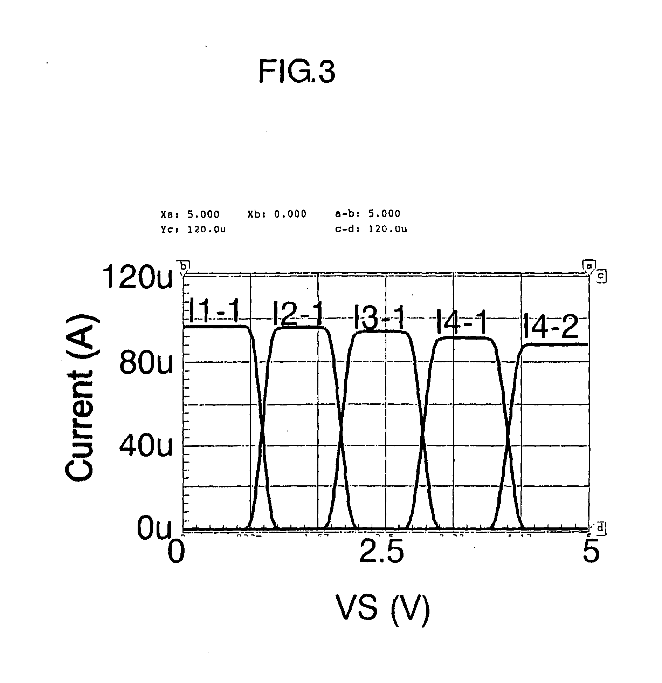

As the control voltage increases and exceeds the first reference voltage VR1, the current flowing into the Q3 gradually decreases, and the most of the current starts to flow into the Q4. Same applies to the Q5 and Q6, the Q7 and Q8, and the Q9 and Q10, so that the current is shifted and switched in the following manner: I1-1 / Q3 → 12-1/Q5 → I3-1/Q7 → I4-1/Q9 → I4-2/Q10. Fig. 3 shows a graph indicating the variations of currents flowing in the respective transistors.

Note that, although the number of switched blocks is 5 in the present embodiment, the number may be optionally determined, e.g. 3 or dozens. In actual characteristics, the total current value slightly decreases as the control voltage VS increases. This is because, since, from the control voltage generating circuit CVC and the reference voltage generating circuit RVC, the base currents of the transistors forming the respective differential pairs flow into the Q2 which determines the total current, the actual collector currents are lowered by the base currents as compared to the set values thereof, while the base currents increase as the control voltage VS increases, so that the collector currents decrease as the control voltage VS increases.

Members R6 through R9 are resistors which are added in order to limit the base currents. Without these resistors, the base current of the Q4 becomes equal to the value of the total current to be switched, when the control voltage VS exceeds a predetermined value. As a result, the drawing of the current from the outside cannot be performed.

Moreover, if the values of these resistors are too high, an actual switching voltage is higher than the setting value of the switching voltage by the voltage decrease which is figured out by multiplying the resistance values by the base current. On this account, the values of the resistors are preferably in proximity to a value calculated by dividing an allowable deviation from the setting value of the switching voltage by the base current.

When the resistance of the reference voltage generating circuit RVC is low, the power consumption of the reference voltage generating circuit RVC is high. Meanwhile, when the resistance of the reference voltage generating circuit RVC is high, the following problems may occur: a desired corrector current cannot be obtained, or an actual switching voltage is lower than the setting value of the switching voltage determined by the resistance division ratio.

Fortunately, the change of the switching voltage on account of the resistance of the reference voltage generating circuit RVC is in reverse order from the change of the switching voltage on account of the base current limiting resistance. For this reason, the error of the switching voltage can be restrained by appropriately determining the resistance value.

In the current switch circuit of the present embodiment, the bipolar transistors require the voltage difference about 350mV for completely switching the current of the differential pair, on account of the emitter resistance. In the case of silicon bipolar transistors whose emitter resistances are sufficiently low, the required voltage difference for the switching of the differential pair is about 120mV.

The degree of the overlap can be increased by typical means for decreasing the gain of a differential amplifier, e.g. providing a resistor between the emitters of the respective transistors constituting the differential pair and the collector of the transistor functioning as a current source, or Darlington-connecting the transistors constituting the differential pair. On the other hand, the degree of the overlap can be reduced by means which increases the gain.

The present embodiment adopts the NPN bipolar transistors. Alternatively, as a second example, it is possible to fabricate a circuit which switches a discharged (drained) current rather than a drawn current, by adopting PNP bipolar transistors.

### [Second Embodiment]

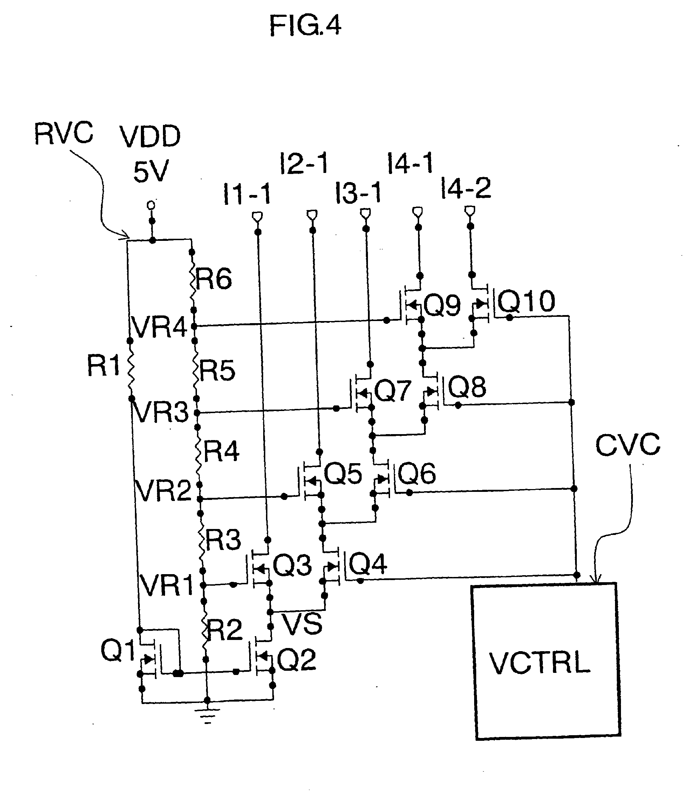

Fig. 4 shows a circuit diagram of Second Embodiment of the present invention. This circuit adopts N-type MOSFETs as elements. All elements have Idss about 1mA. The power supply voltage is 5V. A member R1 is a resistor for determining the total current. Since the current of 100µA is required, a value of the resistor R1 is 45.5kΩ in the MOSFET of the present embodiment.

The current is converted to the drawn current of the Q2, by a current mirror circuit made up of the Q1 and Q2, and the drawn current acts as the current source. The current mirror circuit may be replaced with a circuit such as a bandgap reference, to improve temperature characteristics and enhance the tolerance for the variation between elements. In the present embodiment, the current is simply set by the resistor, as an example of a simple circuit.

The Q3 and Q4, the Q5 and Q6, the Q7 and Q8, and the Q9 and Q10 constitute the respective differential pairs. From the R2 to the R6 generates reference voltages VR1, VR2, VR3, and VR4 for the switching signals. Values of all resistors are 50kΩ.

When the switch elements are MOSFETs, no current flows into the gate, so that the current consumption of the reference voltage generating circuit RVC can be reduced by adopting resistors whose values are as high as possible, on condition that the current flowing in the reference voltage generating circuit RVC is sufficiently higher than the gate leak current.

However, in order to obtain high resistance values, the resistors need to be very long on the IC and hence the chip size is enlarged. For this reason, the values of the resistors are set to 50kΩ in the present case. Note that, although the reference voltage generating circuit RVC adopts a simple divider which attenuates the voltage by cascaded resistors, a bandgap reference and the like may be adopted for a part requiring high precision.

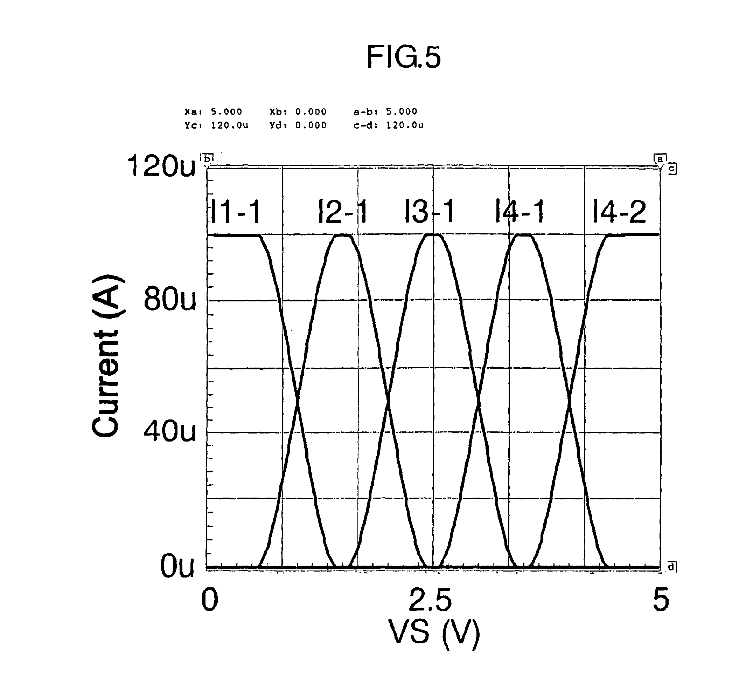

Fig. 5 shows the current switching characteristics of this circuit. Being different from the case where the bipolar transistors are adopted, the total switch current in the case of adopting the MOSFETs is constant irrespective of the control voltage VS, because no gate current flows. Moreover, since gm (mutual conductance) is lower than that of the bipolar transistors, the degree of the overlap of the switching is large and the switching characteristics are smoother.

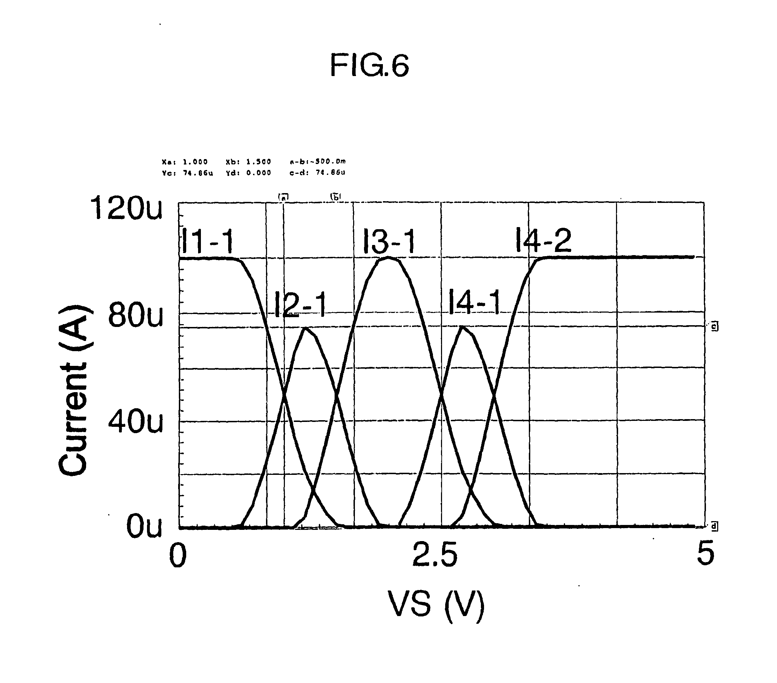

In the present embodiment, the values of the resistors R2-R6 of the reference voltage generating circuit RVC are identical to each other. Alternatively, the switching voltage can be optionally set by changing the values of the resistors. As an example, Fig. 6 shows the change of currents in a case where the R2 and R4 are 100kΩ, the R3 and R5 are 50kΩ, and the R6 is 200kΩ. In this case, the control voltages with which two of the currents are equalized are 1V, 1.5V, 2.5V, and 3V, which are figured out by dividing 5V (power supply voltage) by voltages attenuated by cascaded resistors.

When the MOSFETs of this circuit are adopted, the input voltage difference required for completely switching the current of the differential pair is about 0.5V, so that the overlap of currents is frequently observed, i.e. each current frequently flows in more than one current path. The degree of this overlap can be reduced by increasing gm (mutual conductance) of the MOSFET by, for instance, widening the gate. On the contrary, the degree of the overlap can be increased by narrowing the gate width. Also, as illustrated in First Embodiment, the degree of the overlap can be adjusted using means for adjusting the gain of a differential amplifier and adjusting linearity.

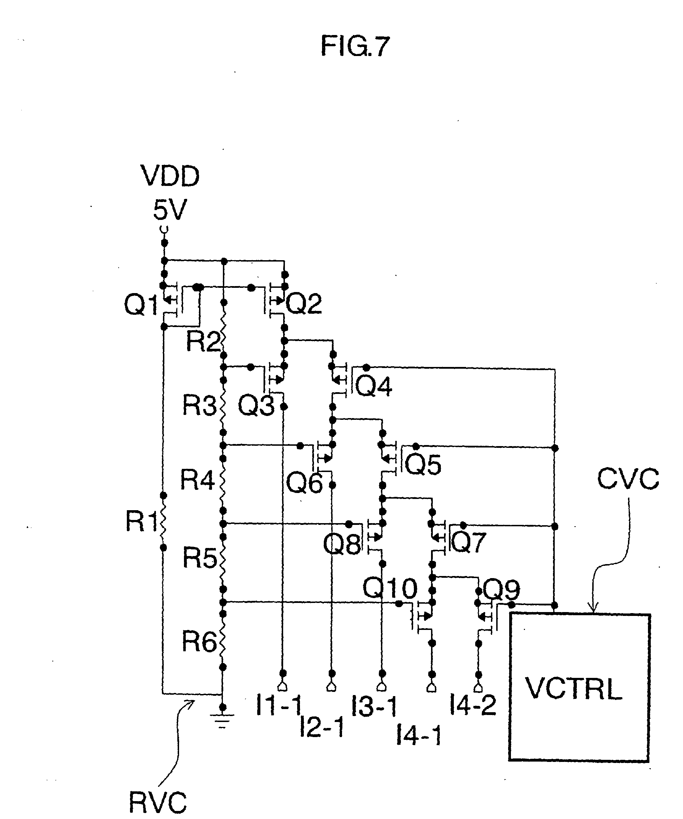

In the present embodiment, the circuit is made up of the N-type MOSFETs, so that the drawn currents are controlled. Alternatively, adopting P-type MOSFETs as shown in Fig. 7, it is possible to fabricate a current switch circuit of a current-draining type, as a second example.

### [Third Embodiment]

A draining-type switchable current source is often more convenient than a drawing-type switchable current source. As described above, Such current sources can be realized by fabricating a current switch circuit by adopting P-type MO SFETS or PNP-type bipolar transistors.

However, a PNP-type bipolar transistor on an IC is typically a horizontal type, and whose characteristics such as current gain are significantly low. Moreover, when the number of the stages of the differential pairs increases, the voltages between the source and drain of the MOSFET and between the emitter and collector of the bipolar transistor pile up, and as a result the maximum voltage as a constant current source decreases, thereby the degradation of the characteristics being induced.

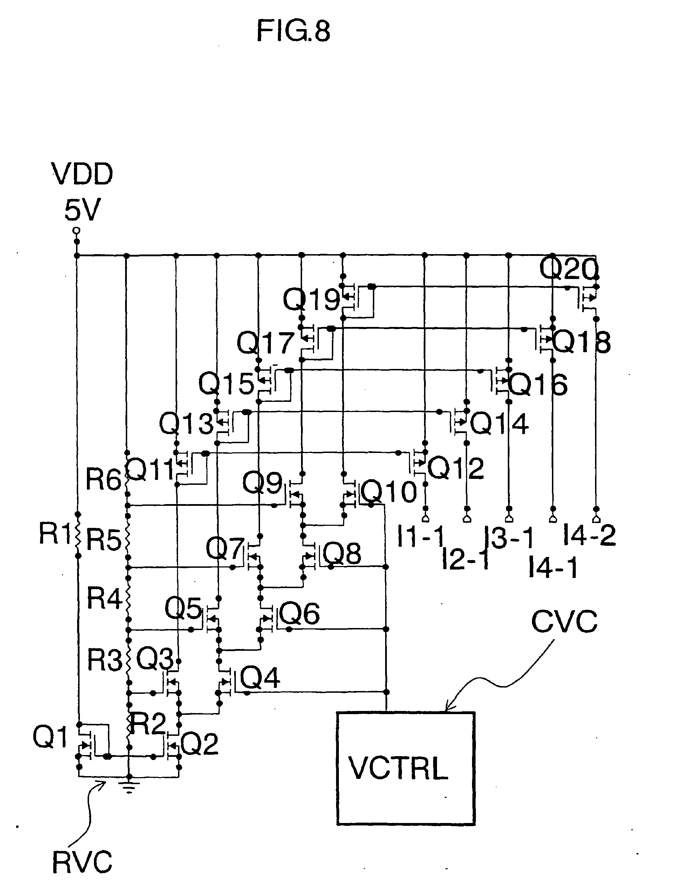

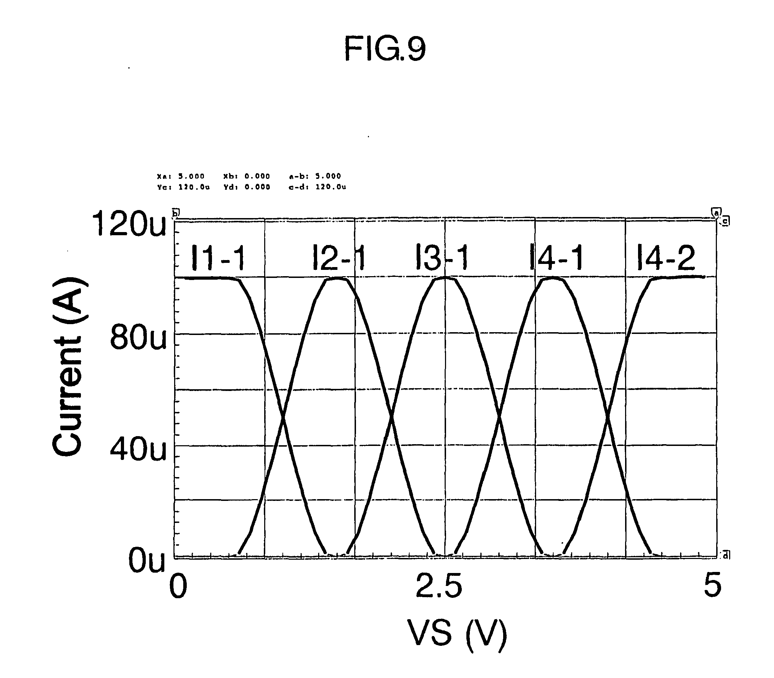

To solve this problem, as shown in Fig. 8, Third Embodiment of the present invention adopts circuitry in which a current switch circuit is made up of N-type MOSFETs, and the drawn currents are mirrored by current mirror circuits made up of P-type MOSFETs and consequently currents are discharged (drained). With this, the maximum voltage functioning as a constant current source is constant in all current paths, and desired characteristics can be obtained at a voltage not more than a voltage figured out by subtracting, from VDD, the minimum source-drain voltage with which the P-type MOSFET can operate as the constant current source. Fig. 9 shows current switching characteristics of this case.

Moreover, in the current mirror circuits made up of the P-type MOSFETs, the current values on the paths can be varied by setting the gate widths of the respective MOSFETs to be different from each other (note that, some of the gates may have identical widths). In the conventional circuit, the total current is constant, and basically the currents flowing in the respective circuit paths are identical with each other, even if a slight change occurs on account of the overlap. However, in some types of circuits, the currents on the respective paths are preferably different from each other. In such a case, the currents on the paths can be changed by appropriately setting the gate widths of the respective MOSFETs constituting the current mirror circuits. When the current mirror circuits for the mirroring are made up of PNP-type bipolar transistors, an effect similar to the above can be obtained by causing the sizes of the emitters of the respective bipolar transistors to be different from each other.

In the present embodiment, the current switching circuit and the current mirror circuit are both made up of MOSFETs. Alternatively, at least one of these circuits may be made up of bipolar transistors. In this case, unlike the case of using the MOSFETs, an error on account of the base current has to be taken into consideration. Having said that, the emitter-collector voltage of the bipolar transistor is generally higher than the minimum source-drain voltage functioning as a constant current source of the MOSFET, and an early voltage of the bipolar transistor, which indicates the dependency of the collector current on the collector voltage, is higher than that of the MOSFET. For these reasons, it is preferable that an optimum combination of transistors is chosen in consideration of the use of the circuit.

### [Fourth Embodiment]

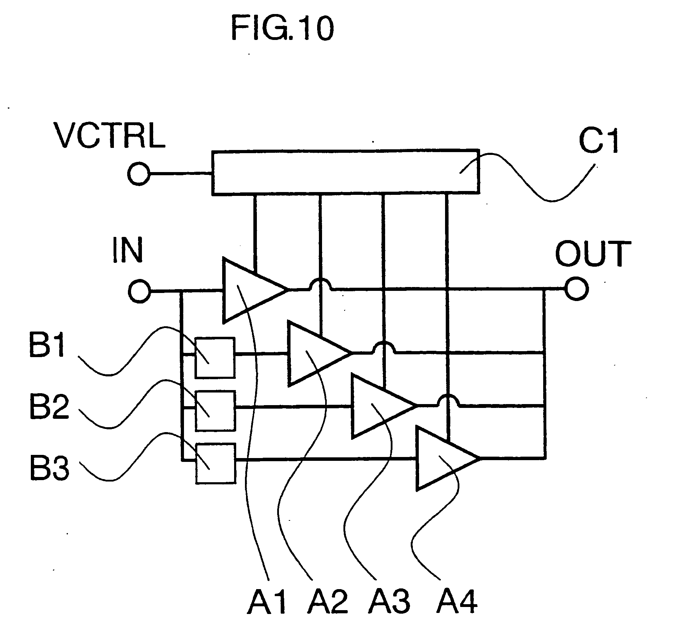

A variable-gain amplifier of the present invention can realize high linearity at the time of low gain by combining the current switch circuit of the present invention with variable-gain amplifiers and passive attenuators. Fig. 10 illustrates a block diagram of this variable-gain amplifier.

Each of members A1 through A4 is an amplifier whose gain can be varied by changing a current flowing into the control terminal. These amplifiers do not ·operate at all when the control current is 0. Each of the amplifiers A1 through A4 in operation have specific constant linearity, and no distortion occurs when the amplifier is completely out of action.

As a current switch circuit C1, a circuit which can drain a current as shown in Fig. 8 can be adopted. Also, other types of circuits such as a circuit shown in Fig. 7 and a circuit adopting PNP-type bipolar transistors can be adopted.

Next, the operation of the above will be discussed. When the control current is controlled and the amplifier A1 is in operation, the remaining amplifiers are in off state. As to an input conversion distortion (IIP3, 3rd Order Input Intermodulation Intercept Point) which is a parameter of linearity, the IIP3 in this case is identical with that of the amplifier A1.

When the control current is varied and the amplification operation completely shifts from the amplifier A1 to the amplifier A2, the overall gain of the amplifiers is equivalent to a value calculated by subtracting the attenuation factor of the attenuator B1 from the gain of the amplifier A2. The IIP3 on this occasion is equal to a value calculated by adding the attenuation factor of the attenuator B1 to the IIP3 of the amplifier A2. Therefore, the overall IIP3 of the amplifiers increases.

In this manner, the gain is minimized when the amplifier A4 operates. This gain is calculated by subtracting the sum total of the attenuation factors of the attenuators B1, B2 and B3 from the gain of the amplifier A4. The IIP3 on this occasion is equal to the sum total of the IIP3 of the amplifier A4 and the attenuation factors of the attenuators B1, B2, and B3, so that the linearity is significantly improved in comparison with a case where the amplifier A4 singly operates.

The variable-gain amplifier being thus manufactured has a low noise level at a high gain, while the linearity increases as the gain decreases. Also, the aforementioned circuitry including the amplifiers can successfully operate with a power supply voltage about 3V which can be generated by a lithium battery and the like.

A wireless mobile terminal requires a wide dynamic range as a receiving characteristic, because a received power greatly varies depending on the environment of use.

In such a mobile terminal, the C/N ratio (ratio between signal and noise) is sufficient when the received power is high, so that the noise characteristics and high-gain of a receiving section of the mobile terminal do not really have importance. On the other hand, in this case the linearity that indicates low distortion in the receiving section is important, on account of the higher received power. When, meanwhile, the received power is low, distortion does not frequently occur in the receiving section but the C/N ratio is insufficient, and hence the amplifier of the receiving section needs to have a high gain and low noise level.

Adopting the amplifier of the present invention to the aforesaid mobile terminal, the receiving characteristics of the mobile terminal are improved.

In the current switch circuit of the present invention, a lot of switching paths can be provided even if the power supply voltage is low (about 3V). On this account, the current switch circuit of the present invention can be suitably used for an amplifier of a battery-driven mobile terminal.

To solve the above-identified problem, a current switch circuit of the present invention is characterized by comprising: first through n-th (n is an integer not less than 2) differential pairs (D1, D2, D3) each including first and second control terminals, first and second switched current terminals, and one common terminal; a constant current section (CS); a reference voltage section (RVC) which supplies first through n-th reference voltages to the respective first control terminals of the first through n-th differential pairs, said first through n-th reference voltages being different from each other; and a control section (CVC) which changes control voltages applied to the respective second control terminals of the first through n-th differential pairs, the common terminal of the first differential pair being connected to the constant current section (CS), the second switched current terminal of the first differential pair (D1) being connected to the common terminal of the second differential pair (D2), and the common terminals of the third through n-th differential pairs being connected respectively to the second switched current terminals of the second through (n-1)th differential pairs, and by the control section (CVC), a current being shifted from the first switched current terminal of the first differential pair (D1) to the second switched current terminal of the n-th differential pair, via the first switched current terminals of the second through (n-1)th differential pairs.

According to this arrangement, when the differential pairs are made up of either NPN-type bipolar transistors or N-type field effect transistors, a current is drawn to the switched current terminal on the side of the control terminal whose voltage in comparison with the voltage of the common terminal is higher than the other. On the other hand, when the differential pairs are made up of PNP-type bipolar transistors or P-type field effect transistors, a current is discharged (drained) from the switched current terminal on the side of the control terminal whose voltage in comparison with the common terminal is lower than the other.

In the arrangement above, the control voltage at the time of switching the current paths is basically equal to the reference voltage. On this account, constructing the reference voltage section by simple resistance division, the current switching voltage can be easily set only by the resistors. In the arrangement above, furthermore, the differential pairs are adopted and hence no current flows into the control section. Thus, the control section is no longer required to control the bipolar operation, thereby being simplified.

Furthermore, in the arrangement above, the control voltage can be lowered by lowering the upper limits of the reference voltages. On this account, the switching of the current paths is easily controlled even if the power supply voltage is low (about 3V), and hence the arrangement can be used for a wide variety of uses.

As a first example, the aforesaid current switch circuit may be arranged in such a manner that, each of the differential pairs is made up of first and second transistors which are either NPN-type bipolar transistors or N-type field effect transistors, and an emitter or source (hereinafter, emitter) of the first transistor is connected to an emitter of the second transistor, a base or gate (hereinafter, base) which is the first control terminal of the first differential pair receives the first reference voltage, a first base of the second differential pair receives the second reference voltage which is higher than the first reference voltage, and the first control terminals of the third through n-th differential pairs respectively receive the third through n-th reference voltages which are respectively higher than the second to (n-1)th reference voltages, and second bases which are the second terminals of the first through n-th differential pairs are connected to the control section, so that, as output voltages from the control section increase, a target of a current inflow shifts from a first collector or first drain (hereinafter, first collector) which is the first switched current terminal of the first differential pair to a second collector which is the second switched current terminal of the n-th differential pair, via the first collectors of the second through (n-1)th differential pairs.

According to this arrangement, each of the differential pairs is made up of either NPN-type bipolar transistors or N-type field effect transistors. On this account, amounts of drawn currents on a plurality of current paths can be controlled.

In the arrangement above, when the bipolar transistors are adopted, currents flow from the control section to the differential pairs but currents do not flow into the control section. For this reason, the control section does not need to control the bipolar operation. When, meanwhile, the field effect transistors are adopted, currents rarely flow from the control section to the differential pairs. Therefore, the arrangement above makes it possible to significantly simplify the control section.

As a second example in place of the first example, the aforesaid current switch circuit may be arranged in such a manner that, each of the differential pairs is made up of first and second transistors which are either PNP-type bipolar transistors or P-type field effect transistors, and an emitter or source (hereinafter, emitter) of the first transistor is connected to an emitter of the second transistor, a base or gate (hereinafter, base) which is the first control terminal of the first differential pair receives the first reference voltage, a first base of the second differential pair receives the second reference voltage which is lower than the first reference voltage, and the first bases of the third through n-th differential pairs respectively receive the third through n-th reference voltages which are respectively lower than the second to (n-1)th reference voltages, and second bases which are the second terminals of the first through n-th differential pairs are connected to the control section, so that, as output voltages from the control section decrease, a target of a current outflow shifts from a first collector or first drain (hereinafter, first collector) which is the first switched current terminal of the first differential pair to a second collector which is the second switched current terminal of the n-th differential pair, via the first collectors of the second through (n-1)th differential pairs.

This circuitry of the second example is different from the circuitry of the first example, in the respect that in the second example amounts of draining currents on a plurality of currents paths are controlled. In general, the switching of current supply can be used for a wider variety of uses. The circuit of the second example realizes such switching of current supply.

On the contrary to the aforesaid circuit, when the bipolar transistors are adopted, the control currents flow from the respective differential pairs to the control section. When, meanwhile, the field effect transistors are adopted, the control currents hardly flow.

In the current switch circuit of the first example, current mirror circuits each made up of PNP-type bipolar transistors or P-type field effect transistors and mirroring the current inflow to the current outflow may be provided with respect to the respective collectors of the differential pairs.

This circuit operates in a similar manner as the circuit of the second example. However, since the current outflow circuit is made up of current mirror circuits, only one transistor is provided in the current path, thereby making it possible to increase the upper limit of the voltage, with which the current can be kept to be constant, to the proximity of the upper limit of the power supply voltage. On this account, the voltage range with which a constant current is supplied is widened. Moreover, since the current flows from the control section to the current switch circuit, the control section has a simple structure.

The emitter sizes or gate widths of the transistors in the aforesaid current mirror circuits may be different from each other.

### (Effect of the Invention)

Being different from conventional circuits, the current switch circuit of the present invention switches cascaded differential pairs (differential circuits), and hence a current hardly flows in a control section and the current is either flow in or flow out, so that the bipolar operation is unnecessary. In the present invention, voltages for switching a current can be arranged so as to uniquely correspond to reference voltages. For this reason, the switching voltage can be easily and freely set.

Furthermore, according to the present invention, the switching of the current can be done with a voltage in the range of about 100mV through 200mV, when silicon bipolar transistors are adopted. For this reason, a current switch circuit having a lot of switching paths can be easily realized even if the power supply voltage is low (about 3V), let alone a high voltage.

The invention being thus described, it will be obvious that the same way may be varied in many ways. Such variations are not to be regarded as a departure from the spirit and scope of the invention, and all such modifications as would be obvious to one skilled in the art are intended to be included within the scope of the following claims.

## Claims

1. A current switch circuit, **characterized by** comprising:
first through n-th (n is an integer not less than 2) differential pairs (D1, D2, D3) each including first and second control terminals, first and second switched current terminals, and one common terminal;
a constant current section (CS);
a reference voltage section (RVC) which supplies first through n-th reference voltages to the respective first control terminals of the first through n-th differential pairs, said first through n-th reference voltages being different from each other; and
a control section (CVC) which changes control voltages applied to the respective second control terminals of the first through n-th differential pairs,
the common terminal of the first differential pair being connected to the constant current section (CS), the second switched current terminal of the first differential pair (D1) being connected to the common terminal of the second differential pair (D2), and the common terminals of the third through n-th differential pairs being connected respectively to the second switched current terminals of the second through (n-1)th differential pairs, and
by the control section (CVC), a current being shifted from the first switched current terminal of the first differential pair (D1) to the second switched current terminal of the n-th differential pair, via the first switched current terminals of the second through (n-1)th differential pairs.

2. The current switch circuit as defined in claim 1,
wherein, each of the differential pairs is made up of first and second transistors which are either NPN-type bipolar transistors or N-type field effect transistors, and an emitter or source (hereinafter, emitter) of the first transistor is connected to an emitter of the second transistor,
a base or gate (hereinafter, base) which is the first control terminal of the first differential pair receives the first reference voltage, a first base of the second differential pair receives the second reference voltage which is higher than the first reference voltage, and the first control terminals of the third through n-th differential pairs respectively receive the third through n-th reference voltages which are respectively higher than the second to (n-1)th reference voltages, and
second bases which are the second terminals of the first through n-th differential pairs are connected to the control section, so that, as output voltages from the control section increase, a target of a current inflow shifts from a first collector or first drain (hereinafter, first collector) which is the first switched current terminal of the first differential pair to a second collector which is the second switched current terminal of the n-th differential pair, via the first collectors of the second through (n-1)th differential pairs.

3. The current switch circuit as defined in claim 1,
wherein, each of the differential pairs is made up of first and second transistors which are either PNP-type bipolar transistors or P-type field effect transistors, and an emitter or source (hereinafter, emitter) of the first transistor is connected to an emitter of the second transistor,
a base or gate (hereinafter, base) which is the first control terminal of the first differential pair receives the first reference voltage, a first base of the second differential pair receives the second reference voltage which is lower than the first reference voltage, and the first bases of the third through n-th differential pairs respectively receive the third through n-th reference voltages which are respectively lower than the second to (n-1)th reference voltages, and
second bases which are the second terminals of the first through n-th differential pairs are connected to the control section, so that, as output voltages from the control section decrease, a target of a current outflow shifts from a first collector or first drain (hereinafter, first collector) which is the first switched current terminal of the first differential pair to a second collector which is the second switched current terminal of the n-th differential pair, via the first collectors of the second through (n-1)th differential pairs.

4. The current switch circuit as defined in claim 2, wherein, current mirror circuits each made up of PNP-type bipolar transistors or P-type field effect transistors and mirroring the current inflow to the current outflow are provided with respect to the respective collectors of the differential pairs.

5. The current switch circuit as defined in claim 4, wherein, sizes of emitters or widths of gates of the transistor in the respective current mirror circuits are different from each other.

6. The current switch circuit as defined in any one of claims 1-5, wherein, said first and second transistors constituting each of the differential pairs are field effect transistors.

7. An amplifier, **characterized by** comprising the current switch circuit defined in any one of claims 1-6.

8. A mobile terminal, comprising the current switch circuit defined in any one of claims 1-6.

9. A mobile terminal, comprising the amplifier defined in claim 7.

## Patentansprüche

1. Stromschalter, **dadurch gekennzeichnet, dass** er umfasst:
erste bis n-te (n ist eine ganze Zahl nicht weniger als 2) Differentialpaare (D1, D2, D3), wobei jedes erste und zweite Steueranschlüsse, erste und zweite geschaltete Stromanschlüsse, und einen gemeinsamen Anschluss umfasst;
einen Konstantstromabschnitt (CS);
einen Referenzspannungsabschnitt (RVC), welcher erste bis n-te Referenzspannungen zu den entsprechenden ersten Steueranschlüssen der ersten bis n-ten Differentialpaare liefert, wobei die ersten bis n-ten Referenzspannungen unterschiedlich voneinander sind; und
einen Steuerabschnitt (CVC), der die an die entsprechenden zweiten Steueranschlüsse der ersten bis n-ten Differentialpaare angelegte Steuerspannung verändert,
wobei der gemeinsame Anschluss des ersten Differentialpaares mit dem Konstantstromabschnitt (CS) verbunden ist, der zweite geschaltete Stromanschluss des ersten Differentialpaares (D1) mit dem gemeinsamen Anschluss des zweiten Differentialpaares (D2) verbunden ist, und die gemeinsamen Anschlüsse der dritten bis n-ten Differentialpaare entsprechend mit den zweiten geschalteten Stromanschlüssen des zweiten durch (n-1)ten Differentialpaare verbunden sind, und
wobei durch den Steuerabschnitt (CVC) ein Strom von dem ersten geschalteten Stromanschluss des ersten Differentialpaares (D1) zu dem zweiten geschalteten Stromanschluss des n-ten Differentialpaares über die ersten geschalteten Stromanschlüsse der zweiten bis (n-1)ten Differentialpaare umgeschaltet wird.

2. Der Stromschalter nach Anspruch 1,
wobei jeder der Differentialpaare aus ersten und zweiten Transistoren hergestellt ist, welche entweder bipolare Transistoren vom NPN-Typ oder Feldeffekttransistoren vom N-Typ sind, und ein Emitter oder eine Quelle (nachfolgend Emitter) des ersten Transistors mit einem Emitter des zweiten Transistors verbunden ist,
wobei eine Basis oder ein Gate (nachfolgend Basis), welche/s der erste Steueranschluss des ersten Differentialpaares ist, die erste Referenzspannung empfängt, eine erste Basis des zweiten Differentialpaares die zweite Referenzspannung empfängt, welche höher als die erste Referenzspannung ist, und die ersten Steueranschlüsse der dritten bis n-ten Differentialpaare entsprechend die dritten bis n-ten Referenzspannungen empfangen, welche entsprechend höher als die zweiten bis (n-1)ten Referenzspannungen sind, und
wobei zweite Basisanschlüsse, welche die zweiten Anschlüsse der ersten bis n-ten Differentialpaare sind, mit dem Steuerabschnitt verbunden sind, so dass, wenn die Ausgangsspannungen von dem Steuerabschnitt ansteigen, sich ein Ziel eines Stromzuflusses von einem ersten Kollektor oder ersten Drain (nachfolgend erster Kollektor), welcher der erste geschaltete Stromanschluss des ersten Differentialpaares ist, zu einem zweiten Kollektor, welcher der zweite geschaltete Stromanschluss des n-te Differentialpaares ist, über die ersten Kollektoren der zweiten bis (n-1)ten Differentialpaare verlagert.

3. Der Stromschalter nach Anspruch 1,
wobei jeder der Differentialpaare aus ersten und zweiten Transistoren hergestellt ist, welche entweder bipolare Transistoren vom PNP-Typ oder Feldeffekttransistoren vom P-Typ sind, und ein Emitter oder Quelle (nachfolgend Emitter) des ersten Transistors mit einem Emitter des zweiten Transistors verbunden ist,
wobei eine Basis oder ein Gate (nachfolgend Basis), welche/s der erste Steueranschluss des ersten Differentialpaares ist, die erste Referenzspannung empfängt, eine erste Basis des zweiten Differentialpaares die zweite Referenzspannung empfängt, welche niedriger als die erste Referenzspannung ist, und die ersten Basisanschlüsse der dritten bis n-ten Differentialpaare entsprechend die dritten bis n-ten Referenzspannungen empfangen, welche entsprechend niedriger als die zweiten bis (n-1)ten Referenzspannungen sind, und
wobei zweite Basisanschlüsse, welche die zweiten Anschlüsse der ersten bis n-ten Differentialpaare sind, mit dem Steuerabschnitt verbunden sind, so dass, wenn die Ausgangsspannungen von dem Steuerabschnitt abfallen, sich ein Ziel eines Stromabflusses von einem ersten Kollektor oder einem ersten Drain (nachfolgend erster Kollektor), welcher der erste geschaltete Stromanschluss des ersten Differentialpaares ist, zu einen zweiten Kollektor, welcher der zweite geschaltete Stromanschluss des n-ten Differentialpaares ist, über die ersten Kollektoren des zweiten bis (n-1)ten Differentialpaare verlagert.

4. Der Stromschalter nach Anspruch 2, wobei Stromspiegelschaltungen, die aus bipolaren Transistoren vom PNP-Typ oder Feldeffekttransistoren vom P-Typ hergestellt sind und die den Stromzufluss zu dem Stromabfluss spiegeln, in Bezug auf die entsprechenden Kollektoren der Differentialpaare vorgesehen sind.

5. Stromschalter nach Anspruch 4, wobei die Größen der Emitter oder die Weiten der Gateanschlüsse des Transistors in den jeweiligen Stromspiegelschaltungen unterschiedlich voneinander sind.

6. Der Stromschalter nach einem der Ansprüche 1 bis 5, wobei die ersten und zweiten Transistoren, die jede der Differentialpaare bilden, Feldeffekttransistoren sind.

7. Verstärker, **dadurch gekennzeichnet, dass** er den Stromschalter umfasst, der in einen der Ansprüche 1 - 6 definiert ist.

8. Mobiles Endgerät, das den Stromschalter umfasst, der in einem der Ansprüche 1 - 6 definiert ist.

9. Mobiles Endgerät, das den Verstärker umfasst, der in Anspruch 7 definiert ist.

## Revendications

1. Circuit commutateur de courant **caractérisé en ce qu'**il comprend :
des première à nième (n étant un nombre entier non inférieur à 2) paires différentielles (D1, D2, D3) comprenant chacune des première et seconde bornes de commande, des première et seconde bornes de courant commuté et une borne commune ;
une partie à courant constant (CS) ;
une partie génératrice de tension de référence (RVC) qui fournit des première à nième tensions de référence aux premières bornes de commande respectives des première à nième paires différentielles, lesdites première à nième tensions de référence étant différentes les unes des autres ; et
une partie de commande (CVC) qui change des tensions de commande appliquées aux secondes bornes de commande respectives des première à nième paires différentielles,
la borne commune de la première paire différentielle étant reliée à la partie à courant constant (CS), la seconde borne de courant commuté de la première paire différentielle (D1) étant reliée à la borne commune de la deuxième paire différentielle (D2) et les bornes communes des troisième à nième paires différentielles étant respectivement reliées aux secondes bornes de courant commuté des deuxième à n-lième paires différentielles, et
un courant étant amené par la partie de commande (CVC) à passer de la première borne de courant commuté de la première paire différentielle (D1) à la seconde borne de courant commuté de la nième paire différentielle, par l'intermédiaire des premières bornes de courant commuté des deuxième à n-lième paires différentielles.

2. Circuit commutateur de courant tel que défini dans la revendication 1, dans lequel
chacune des paires différentielles est composée de premier et second transistors qui sont des transistors bipolaires de type NPN ou des transistors à effet de champ de type N, un émetteur ou une source (ci-après un émetteur) du premier transistor étant relié à un émetteur du second transistor,
une base ou une grille (ci-après une base) constituant la première borne de commande de la première paire différentielle reçoit la première tension de référence, une première base de la deuxième paire différentielle reçoit la deuxième tension de référence qui est supérieure à la première tension de référence, et les premières bornes de commande des troisième à nième paires différentielles reçoivent respectivement les troisième à nième tensions de référence qui sont respectivement supérieures aux deuxième à n-lième tensions de référence, et
des secondes bases qui constituent les secondes bornes des première à nième paires différentielles sont reliées à la partie de commande afin que, lorsque des tensions de sortie de la partie de commande augmentent, une cible d'une entrée de courant passe d'un premier collecteur ou d'un premier drain (ci-après un premier collecteur) qui constitue la première borne de courant commuté de la première paire différentielle à un second collecteur qui constitue la seconde borne de courant commuté de la nième paire différentielle, par l'intermédiaire des premiers collecteurs des deuxième à n-lième paires différentielles.

3. Circuit commutateur de courant tel que défini dans la revendication 1, dans lequel
chacune des paires différentielles est composée de premier et second transistors qui sont des transistors bipolaires de type PNP ou des transistors à effet de champ de type P, un émetteur ou une source (ci-après un émetteur) du premier transistor étant relié à un émetteur du second transistor,
une base ou une grille (ci-après une base) constituant la première borne de commande de la première paire différentielle reçoit la première tension de référence, une première base de la deuxième paire différentielle reçoit la deuxième tension de référence qui est inférieure à la première tension de référence, et les premières bases des troisième à nième paires différentielles reçoivent respectivement les troisième à nième tensions de référence qui sont respectivement inférieures aux deuxième à n-lième tensions de référence, et
des secondes bases qui constituent les secondes bornes des première à nième paires différentielles sont reliées à la partie de commande afin que, lorsque des tensions de sortie de la partie de commande diminuent, une cible d'une sortie de courant passe d'un premier collecteur ou d'un premier drain (ci-après un premier collecteur) qui constitue la première borne de courant commuté de la première paire différentielle à un second collecteur qui constitue la seconde borne de courant commuté de la nième paire différentielle, par l'intermédiaire des premiers collecteurs des deuxième à n-lième paires différentielles.

4. Circuit commutateur de courant tel que défini dans la revendication 2, dans lequel des circuits miroirs de courant composés chacun de transistors bipolaires de type PNP ou de transistors à effet de champ de type P et rendant symétriques l'entrée de courant et la sortie de courant sont prévus en ce qui concerne les collecteurs respectifs des paires différentielles.

5. Circuit commutateur de courant tel que défini dans la revendication 4, dans lequel des tailles d'émetteurs ou des largeurs de grilles des transistors des circuits miroirs de courant respectifs sont différentes les unes des autres.

6. Circuit commutateur de courant tel que défini dans l'une quelconque des revendications 1 à 5, dans lequel lesdits premier et second transistors constituant chacune des paires différentielles sont des transistors à effet de champ.

7. Amplificateur **caractérisé en ce qu'**il comprend le circuit commutateur de courant défini dans l'une quelconque des revendications 1 à 6.

8. Terminal mobile comprenant le circuit commutateur de courant défini dans l'une quelconque des revendications 1 à 6.

9. Terminal mobile comprenant l'amplificateur défini dans la revendication 7.
